# EUROPÄISCHE PATENTSCHRIFT

(11) **EP 3 231 016 B1**
(45) Veröffentlichungstag und Bekanntmachung des Hinweises auf die Patenterteilung: **17.02.2021**
(21) Anmeldenummer: 15808241.2
(22) Anmeldetag: 11.12.2015
(51) Int. Cl.: H01L 31/0392, H02S 20/00

(54) **PHOTOVOLTAIKMODUL UND PHOTOVOLTAIKSYSTEM**
PHOTOVOLTAIC MODULE AND PHOTOVOLTAIC SYSTEM
MODULE PHOTOVOLTAÏQUE ET SYSTÈME PHOTOVOLTAÏQUE

(30) Priorität: 11.12.2014 DE 102014225631
(43) Veröffentlichungstag der Anmeldung: 18.10.2017
(73) Patentinhaber: TubeSolar AG, 86153 Augsburg (DE)
(72) Erfinder: PETROVA-KOCH, Vesselinka, 85748 Garching (DE); MACKH, Reiner, 86441 Zusmarshausen (DE); GOSS, Annette, 89331 Burgau (DE); MAYER, Johann, 86845 Großaitingen (DE); HÜTTINGER, Roland, 86916 Kaufering (DE); LECKERT, Joerg, 86438 Kissing (DE); WIRTH-SCHÖN, Joachim, 89312 Günzburg (DE)
(74) Vertreter: Hecht, Jan-David
(86) Internationale Anmeldenummer: PCT/EP2015/079475
(87) Internationale Veröffentlichungsnummer: WO 2016/092090

(56) Entgegenhaltungen:
- WO-A1-03/017376
- US-A1- 2005 040 374
- US-A1- 2006 185 714
- US-A1- 2007 227 579
- US-A1- 2008 264 472
- US-B1- 7 235 736

## Beschreibung

Die Druckschriften US 7,196,262 B2 und US 7,394,016 B2 beschreiben jeweils ein Photovoltaikmodul und ein Photovoltaiksystem.

Die WO 03/017376 A1 zeigt eine Thermophotovoltaik-Vorrichtung, bei welcher ein im Zentrum eines Rohres angeordneter Strahlungsemitter elektromagnetische Strahlung abgibt, welche von einer in einem gewissen Abstand auf einem Glasrohr aus hitzebeständigem Quarzglas aufgebrachtes Photovoltaikelement in Strom umgewandelt wird.

Die US 2008/0264472 A1 zeigt eine Photovoltaik-Vorrichtung, innerhalb welcher eine Volumenkompensation möglich ist.

Die US 7,235,736 B1 beschreibt eine Solarzelle, sowie eine monolithische Integration einer zylindrischen Solarzelle.

Die US 2006/0185714 A1 zeigt eine flexible Solarzelle und ein Verfahren zur Herstellung derselben.

Eine zu lösende Aufgabe besteht darin, ein Photovoltaikmodul mit einer erhöhten Effizienz anzugeben. Eine weitere zu lösende Aufgabe besteht darin, ein Photovoltaiksystem mit einer erhöhten Effizienz und einem reduzierten Wartungsaufwand anzugeben.

Es wird ein Photovoltaikmodul angegeben. Das Photovoltaikmodul ist insbesondere zur direkten Umwandlung der in dem Sonnenlicht enthaltenen Energie in elektrische Energie vorgesehen.

Gemäß zumindest einer Ausführungsform des Photovoltaikmoduls umfasst dieses zumindest ein Rohr. Das Rohr weist eine Haupterstreckungsrichtung und eine einem Innenraum des Rohrs zugewandte gekrümmte Innenfläche auf. Das Rohr kann ferner eine der Innenfläche abgewandte gekrümmte Außenfläche aufweisen. Das Rohr ist zum Beispiel zylinderförmig, insbesondere kreiszylinderförmig, ausgebildet und umschließt den Innenraum. Das Rohr ist damit zumindest stellenweise nach Art eines Hohl-Zylinders oder eines Hohl-Kreiszylinders ausgebildet. Die Außenfläche des Rohres kann eine Außenfläche des Photovoltaikmoduls bilden. Das Photovoltaikmodul kann dann den zylinderförmigen Aufbau des Rohres aufweisen.

Das Rohr weist bevorzugt zumindest stellenweise die Form eines Hohl-Kreiszylinders auf. Die Haupterstreckungsrichtung entspricht dann der Höhe des Hohlzylinders. In einem Querschnitt senkrecht zur Haupterstreckungsrichtung weist das Rohr dann die Form eines Kreisrings auf. Der innere Kreis des Kreisrings bildet hierbei die Innenfläche des Rohrs.

Hierbei und im Folgenden sind Begriffe wie "zylinderförmig" und/oder "Hohlzylinder" nicht im streng geometrischen Sinn zu verstehen. Vielmehr kann ein zylinderförmiges Rohr beziehungsweise ein Rohr in Form eines Hohlzylinders auch einen lediglich annähernd kreisförmigen Querschnitt senkrecht zur Haupterstreckungsrichtung aufweisen. Beispielsweise weist das Rohr senkrecht zur Haupterstreckungsrichtung einen elliptischen Querschnitt auf, wobei die numerische Exzentrizität der Ellipse höchstens 0,8 beträgt.

Das Rohr ist lichtdurchlässig ausgebildet. "Lichtdurchlässig" bedeutet hierbei und im Folgenden, dass wenigstens 90 %, bevorzugt wenigstens 94 %, des auf das lichtdurchlässige Material auftreffenden Lichts durch das Material transmittiert wird. Beispielsweise ist das Rohr mit einem Glas oder einem Kunststoff gebildet oder besteht aus einem Glas oder einem Kunststoff. Beispielsweise ist das Rohr mit Kalknatronsilicatglas gebildet oder besteht aus Kalknatronsilicatglas. Kalknatronsilicatglas zeichnet sich insbesondere durch seinen geringen Preis aus.

Die Bruchfestigkeit des verwendeten Glases kann durch eine schnelle Abkühlung und/oder anderer spezieller In-Line-Verfahren erhöht werden. Dies ermöglicht insbesondere einen Einsatz des Rohres unter widrigen Umweltbedingungen. Zur Verbesserung der Transmissionseigenschaften des Materials des Rohres kann die Außenfläche des Rohrs zusätzlich entspiegelt werden. Beispielsweise wird hierzu eine Antireflex-Beschichtung auf die Außenfläche des Rohrs aufgebracht.

Gemäß zumindest einer Ausführungsform des Photovoltaikmoduls umfasst dieses ferner ein mechanisch flexibles Photovoltaikbauteil. Das Photovoltaikbauteil umfasst eine auf einer Trägerfolie aufgebrachte Solarzellenanordnung. Eine Solarzellenanordnung kann hierbei und im Folgenden aus einer oder mehreren, insbesondere in Reihe geschalteten, Solarzellen bestehen. Die Solarzellenanordnung umfasst zumindest eine aktive Schicht, in welcher bei Einfall von Sonnenlicht freie Ladungsträger erzeugt werden können.

Das Photovoltaikbauteil ist mechanisch flexibel ausgebildet. Insbesondere sind die Solarzellenanordnung und die Trägerfolie mechanisch flexibel ausgebildet. "Mechanisch flexibel" bedeutet hierbei und im Folgenden, dass ein zerstörungsfreies Biegen, Aufrollen und/oder Krümmen des Photovoltaikbauteils erfolgen kann. Insbesondere kann das Photovoltaikbauteil - auch mehrmals - aufgerollt und/oder gebogen werden ohne dass dessen elektrische und/oder optische Eigenschaften verändert werden.

Gemäß zumindest einer Ausführungsform des Photovoltaikmoduls ist das Photovoltaikbauteil in dem Innenraum des Rohrs angeordnet. Das Photovoltaikbauteil kann insbesondere vollständig in dem Innenraum angeordnet sein. Das Photovoltaikbauteil ist dann zumindest senkrecht zur Haupterstreckungsrichtung vollständig von dem Material des Rohrs umschlossen. Bevorzugt grenzt das Photovoltaikbauteil direkt an das Rohr an. Alternativ kann zwischen dem Photovoltaikbauteil und dem Rohr Luft oder ein anderes Gas angeordnet sein.

Gemäß zumindest einer Ausführungsform des Photovoltaikmoduls weist die Solarzellenanordnung eine Krümmung auf. Die Krümmung der Solarzellenanordnung folgt hierbei zumindest stellenweise dem gekrümmten Verlauf der Innenfläche des Rohrs. Mit anderen Worten, in einem Querschnitt senkrecht zur Haupterstreckungsrichtung weisen die Solarzellenanordnung und die Innenfläche eine im mathematischen Sinne ähnliche Krümmung auf. Beispielsweise weist die Innenfläche des Rohrs in einem Querschnitt senkrecht zur Haupterstreckungsrichtung die Form einer Ellipse oder eines Kreises auf. In diesem Fall weist die Solarzellenanordnung zumindest stellenweise die Form einer Ellipse oder eines Kreises auf. Es ist ferner möglich, dass das gesamte Photovoltaikbauteil dem gekrümmten Verlauf der Innenfläche folgt.

Gemäß zumindest einer Ausführungsform des Photovoltaikmoduls überdeckt die Solarzellenanordnung die Innenfläche zumindest teilweise. Mit anderen Worten, in einer Aufsicht auf das Rohr aus dem Innenraum in einer Richtung senkrecht zur Haupterstreckungsrichtung ist die Innenfläche zumindest teilweise von der Solarzellenanordnung bedeckt.
Die überdeckte Innenfläche des Rohrs bildet dann eine Lichtdurchtrittsfläche des Photovoltaikmoduls.

Gemäß zumindest einer Ausführungsform des Photovoltaikmoduls umfasst dieses ein einen Innenraum umschließendes zylinderförmiges lichtdurchlässiges Rohr mit einer Haupterstreckungsrichtung und einer dem Innenraum zugewandten gekrümmten Innenfläche und ein mechanisch flexibles Photovoltaikbauteil mit einer auf einer Trägerfolie aufgebrachten Solarzellenanordnung. Das Photovoltaikbauteil ist in dem Innenraum angeordnet. Die Solarzellenanordnung weist eine Krümmung auf, wobei die Krümmung zumindest stellenweise dem gekrümmten Verlauf der Innenfläche des Rohrs folgt. Die Solarzellenanordnung überdeckt die Innenfläche zumindest teilweise, wobei die überdeckte Innenfläche eine Lichtdurchtrittsfläche des Photovoltaikmoduls bildet.

Die Kombination eines flexiblen Photovoltaikbauteils mit einem lichtdurchlässigen Rohr ermöglicht insbesondere die Ausnutzung eines kostengünstigen Herstellungsprozesses in Verbindung mit einer hohen Effizienz. Die Effizienz des Photovoltaikmoduls ist hierbei und im Folgenden die erzeugte elektrische Energie pro bedeckter Fläche. Der gekrümmte, zum Beispiel zylinderförmige, Aufbau des Photovoltaikmoduls birgt im Vergleich zu konventionellen flächigen Photovoltaikmodulen bezüglich der Effizienz und Lebensdauer des Photovoltaikmoduls mehrere Vorteile. Beispielsweise ist die Querschnittsfläche des Photovoltaikmoduls reduziert, wodurch eine höhere Witterungsbeständigkeit des Photovoltaikmoduls bei beispielsweise einer Wind- und/oder Schneelast erzielt werden kann. Ferner ergibt sich durch eine gekrümmte Außenfläche ein Selbstreinigungseffekt. Durch den zylinderförmigen Aufbau ist zudem das Gewicht des Photovoltaikmoduls im Vergleich zu flachen Photovoltaikmoduls reduziert, wodurch ein Einsatz auf Gebäuden mit statisch gering belastbaren Dächern möglich ist.

Ferner senkt die natürliche Luftzirkulation innerhalb des Rohres die Betriebstemperatur des Photovoltaikmoduls ab. Hierfür kann das Rohr beispielsweise zumindest stellenweise an den Enden geöffnet sein. Generell ist durch den gekrümmten, zum Beispiel zylinderförmigen Aufbau eine Wasser- oder Passivkühlung der Photovoltaikmodule leichter umsetzbar als bei flachen Photovoltaikmodulen. Niedrige Betriebstemperaturen gewährleisten einen hohen Energieertrag und eine verbesserte Funktionssicherheit. Durch die gekrümmte Ausführung des Photovoltaikbauteils kann zudem auch Sonnenlicht mit einem geringen Einfallswinkel, bei beispielsweise tiefstehender Sonne, ausgenutzt werden. Hierdurch ist es möglich, auf eine sogenannte Trackingeinrichtung zur Nachführung des Moduls abhängig vom Sonnenstand in dem Photovoltaikmodul, und dadurch auf aufwändige Mechanik und/oder Elektronik, zu verzichten. Sogar beim Einsatz in Wüstengebieten ist zudem bei einem hier beschriebenen Photovoltaikmodul auch eine passive Kühlung möglich. Dies erhöht den Wirkungsgrad des Photovoltaikmoduls und reduziert gleichzeitig den Wartungsaufwand.

Durch die Erhöhung der Bruchfestigkeit des Rohrs ist die Außenfläche des Rohrs zudem beständiger gegenüber Oberflächenbeschädigungen und/oder kratzfester gegen beispielsweise Sandkörner. Hierdurch können die optischen Eigenschaften des Rohrs auch über einen Langzeiteinsatz in teils widrigen Umweltbedingungen erhalten bleiben.

Gemäß zumindest einer Ausführungsform des Photovoltaikmoduls weist das Photovoltaikbauteil zumindest eine Einkapselungsfolie auf. Die zumindest eine Einkapselungsfolie bedeckt die Solarzellenanordnung des Photovoltaikbauteils an zumindest einer Außenfläche. Beispielsweise bedeckt die zumindest eine Einkapselungsfolie eine der Innenfläche des Rohrs abgewandte Bodenfläche des Photovoltaikbauteils vollständig. Hierbei kann die Einkapselungsfolie mit der Bodenfläche zumindest stellenweise in direktem Kontakt stehen. Die zumindest eine Einkapselungsfolie ist bevorzugt lichtdurchlässig ausgebildet. Ferner kann die zumindest eine Einkapselungsfolie ebenfalls mechanisch flexibel ausgebildet sein.

Gemäß zumindest einer Ausführungsform des Photovoltaikmoduls weist das Photovoltaikbauteil zumindest zwei stoffschlüssig miteinander verbundene Einkapselungsfolien auf. Die Solarzellenanordnung ist vollständig zwischen den zumindest zwei Einkapselungsfolien angeordnet. Bevorzugt grenzt die Solarzellenanordnung stellenweise direkt an die Einkapselungsfolien. Jede Einkapselungsfolie ist bevorzugt mechanisch flexibel ausgebildet. Eine "stoffschlüssige Verbindung" ist hierbei und im Folgenden eine Verbindung, bei der die Verbindungspartner mitunter durch atomare und/oder molekulare Kräfte zusammengehalten werden. Beispielsweise handelt es sich bei einer stoffschlüssigen Verbindung um eine Klebeverbindung und/oder eine Schmelzverbindung. Eine stoffschlüssige Verbindung ist insbesondere nicht zerstörungsfrei lösbar. Mit anderen Worten, die Verbindungspartner können nur unter Verwendung eines Lösungsmittels oder durch Zerstörung getrennt werden.

Beispielsweise kann das Photovoltaikbauteil bis zu drei Einkapselungsfolien aufweisen, wobei die Solarzellenanordnung zwischen wenigstens zwei der Einkapselungsfolien angeordnet ist. Insbesondere können alle Einkapselungsfolien des Photovoltaikbauteils stoffschlüssig miteinander verbunden sein.

Die Einkapselungsfolien können insbesondere dem mechanischen und/oder chemischen Schutz der Solarzellenanordnung vor Umwelteinflüssen dienen. Beispielsweise können die Einkapselungsfolien die Solarzellenanordnung vor Feuchtigkeit schützen. Die Einkapselungsfolien können insbesondere UVbeständig ausgebildet sein. Dies bedeutet, dass die Einkapselungsfolien unter UV-Strahlung auch über lange Zeit hinweg ihre optischen und/oder mechanischen Eigenschaften nicht oder kaum verändern.

Gemäß zumindest einer Ausführungsform des Photovoltaikmoduls weist die Solarzellenanordnung mit einem Querschnitt senkrecht zur Haupterstreckungsrichtung im Rahmen der Herstellungstoleranzen zumindest stellenweise die Form eines Kreisbogens auf. "Im Rahmen der Herstellungstoleranzen" bedeutet hierbei und im Folgenden, dass die Solarzellenanordnung nicht die Form eines Kreisbogens im streng mathematisch-geometrischen Sinne aufweist, sondern Abweichungen, die durch die Herstellung bedingt sein können, vorhanden sein können. Beispielsweise kann die Solarzellenanordnung die Form eines Ellipsenbogens aufweisen, wobei die zugehörige Ellipse eine numerische Exzentrizität von bis zu 0,8 aufweisen kann. Ferner kann die Krümmung des Photovoltaikbauteils nicht gleichmäßig sein.

Gemäß zumindest einer Ausführungsform des Photovoltaikmoduls ist zumindest eine der Einkapselungsfolien eine thermoplastische Folie. Bevorzugt sind alle Einkapselungsfolien thermoplastische Folien. Die thermoplastische Folie kann aus einem Kunststoff gebildet sein. Beispielsweise eignet sich als Material für die Einkapselungsfolie ein silikonbasierter Kunststoff. Eine thermoplastische Folie verändert ihre mechanischen Eigenschaften unter Zufuhr von Wärme. Beispielsweise kann die thermoplastische Folie auf die Solarzellenanordnung auflaminiert werden. Ferner kann die stoffschlüssige Verbindung der Einkapselungsfolien durch Laminieren erzeugt werden. Es ist zusätzlich oder alternativ möglich, dass zumindest eine Einkapselungsfolie mit einem Copolymer, wie beispielsweise Ethylen-Vinylacetat, gebildet ist.

Die Verwendung einer thermoplastischen Folie birgt insbesondere den Vorteil, dass sie selbst unter ungünstigen Umweltbedingungen elektrisch hochisolierend, nichtkorrosiv und hochflexibel ist. Die mechanische Flexibilität ist hierbei sowohl bei niedrigen als auch bei hohen Temperaturen gewährleistet. Ferner ermöglicht die Verwendung einer thermoplastischen Folie ein Recycling des Photovoltaikmoduls am Ende dessen Lebenszyklus. Hierdurch kann ein umweltfreundlich und kostengünstig entsorgbares Photovoltaikmodul bereitgestellt werden.

Gemäß zumindest einer Ausführungsform des Photovoltaikmoduls sind wenigstens 30 % und höchstens 100 % der Innenfläche des Rohrs von der Solarzellenanordnung überdeckt. Bevorzugt sind wenigstens 40 % und höchstens 70 % der Innenfläche des Rohrs von der Solarzellenanordnung überdeckt. Es ist ferner möglich, dass die zumindest eine Einkapselungsfolie wenigstens 20 %, bevorzugt wenigstens 30 %, und höchstens 100 %, bevorzugt höchstens 80 %, der Innenfläche des Rohrs überdeckt. Beispielsweise wird lediglich ein der Sonne zugewandter Anteil der Innenfläche des Rohrs mit der Solarzellenanordnung versehen um Kosten zu sparen. Hierbei ist es möglich, dass die zumindest eine Einkapselungsfolie ebenfalls nicht die gesamte Innenfläche bedeckt, sondern lediglich an der von der Solarzellenanordnung bedeckten Innenfläche angeordnet ist. Es ist ferner möglich, dass wenigstens 30 % und bis zu 100 % der Innenfläche des Rohrs die Lichtdurchtrittsfläche bilden. Beispielsweise ist die eine Hälfte des Mantels des zylinderförmigen Rohrs von der Solarzellenanordnung überdeckt, während die andere Hälfte des Mantels frei von der Solarzellenanordnung ist. Bei dem Mantel des Rohrs kann es sich um die Außenfläche des Rohrs handeln. Hierbei ist es möglich, dass die überdeckte Hälfte des Zylinders nach der Montage des Photovoltaikmoduls der Sonne zugewandt ist, also eine Oberseite des Photovoltaikmoduls bildet.

Gemäß zumindest einer Ausführungsform des Photovoltaikmoduls ist die Lichtdurchtrittsfläche eine einfach zusammenhängende Fläche. Mit anderen Worten, die Solarzellenanordnung überdeckt eine durchgängige Fläche, die keine Ausnehmungen aufweist. Beispielsweise weist die Lichtdurchtrittsfläche im flachen Zustand die Form eines, insbesondere abgerundeten, Rechtecks auf.

Gemäß zumindest einer Ausführungsform des Photovoltaikmoduls ist das Photovoltaikbauteil senkrecht zur Haupterstreckungsrichtung vollständig von dem Rohr umschlossen. Es ist hierbei möglich, dass das Rohr an dessen Enden entlang der Haupterstreckungsrichtung offen ist und/oder der Innenraum an den Enden frei zugänglich ist. Senkrecht zur Haupterstreckungsrichtung ist das Rohr durchgängig und einstückig ausgebildet und umschließt das Photovoltaikbauteil vollständig. Hierdurch kann das Photovoltaikbauteil vor Umwelteinflüssen geschützt werden.

Gemäß zumindest einer Ausführungsform des Photovoltaikmoduls ist die Solarzellenanordnung unter Verwendung eines Druckprozesses auf die Trägerfolie aufgebracht. Beispielsweise kann die Solarzellenanordnung mit einem Tintenstrahldruck auf die Trägerfolie aufgebracht sein. Die Trägerfolie kann eine dünne Stahlfolie oder eine dünne Kunststofffolie sein. Die Trägerfolie ist insbesondere mechanisch flexibel ausgebildet.

Beispielsweise kann die Solarzellenanordnung in einem sogenannten Roll-to-Roll-Prozess auf die Trägerfolie aufgebracht sein. Bei einem solchen Prozess wird zunächst die Trägerfolie als Rolle aufgerollt zur Verfügung gestellt. Anschließend wird die Trägerfolie von der Rolle abgerollt und die Solarzellenanordnung auf die Trägerfolie aufgedruckt. Nach dem Aufdruck-Vorgang wird die Trägerfolie inklusive der auf der Trägerfolie aufgebrachten Solarzellenanordnung wieder aufgerollt. Ein solcher Roll-to-Roll-Prozess ermöglicht insbesondere eine schnelle und kostengünstige Herstellung der Solarzellenanordnung. Es sind jedoch auch andere Herstellungsprozesse denkbar, mit denen eine mechanisch flexible Solarzellenanordnung bereitgestellt werden kann.

Gemäß zumindest einer Ausführungsform des Photovoltaikmoduls ist die Solarzellenanordnung eine CIGS-Solarzellenanordnung oder eine organische Solarzellenanordnung. Eine CIGS-Solarzellenanordnung (CIGS: Copper Indium Gallium Selenide) umfasst als Werkstoffe Kupfer, Indium, Gallium und Diselenid. Eine organische Solarzellenanordnung ist mit organischen Schichten gebildet. Solche Solarzellenanordnungen weisen den Vorteil auf, dass sie in einem, insbesondere kostengünstigen, Druckprozess auf eine Trägerfolie aufgebracht werden können. Die Solarzellenanordnung kann ferner neben den oben genannten Materialien weitere Schichten, wie zum Beispiel eine elektrisch leitfähige Schicht, die beispielsweise mit einem transparenten leitfähigen Oxid gebildet sein kann, enthalten. Ferner kann die Solarzellenanordnung zusätzliche Schichten zur Kontaktierung und/oder zur elektrischen Isolierung enthalten.

Gemäß zumindest einer Ausführungsform des Photovoltaikmoduls weist die Solarzellenanordnung eine Dicke von höchstens 5 µm, bevorzugt höchstens 2,5 µm, auf. Die Dicke der Solarzellenanordnung ist hierbei die Ausdehnung der Solarzellenanordnung senkrecht zu einer Haupterstreckungsebene der Trägerfolie. Die Trägerfolie und/oder die Solarzellenanordnung weisen jeweils entlang der Haupterstreckungsebene der Trägerfolie eine wesentlich größere Ausdehnung auf, als senkrecht zur Haupterstreckungsebene. Bei der Solarzellenanordnung handelt es sich somit um eine Dünnschichtsolarzelle. Eine solche Dünnschichtsolarzelle kann insbesondere mechanisch flexibel ausgebildet sein und mit einem Druckprozess auf eine Trägerfolie aufgebracht werden.

Gemäß zumindest einer Ausführungsform des Photovoltaikmoduls weist das Photovoltaikbauteil ferner ein lichtemittierendes Bauelement auf. Das Bauelement ist mechanisch flexibel ausgebildet. Bei dem lichtemittierenden Bauelement kann es sich beispielsweise um eine mechanisch flexible organische Leuchtdiode handeln. Ferner kann es sich bei dem lichtemittierenden Bauelement um eine Vielzahl anorganischer oder organischer Leuchtdioden handeln die auf einem mechanisch flexiblen Träger angeordnet sind.

Das lichtemittierende Bauelement überdeckt von der Solarzellenanordnung unbedeckte Freibereiche der Innenfläche zumindest stellenweise. Beispielsweise ist die Hälfte des Mantels des zylinderförmigen Rohrs von der Solarzellenanordnung überdeckt. Die zweite Hälfte des Mantels kann dann von dem lichtemittierenden Bauelement überdeckt sein. Hierbei wird insbesondere die Idee verfolgt, dass ein Teil des Photovoltaikmoduls zur Erzeugung von elektrischer Energie aus Sonnenlicht verwendet werden kann, während der andere Teil des Photovoltaikmoduls zur Erzeugung von Licht verwendet werden kann. Ein entsprechendes Modul ist daher ein Hybridmodul.

Das lichtemittierende Bauelement ist elektrisch von der Solarzellenanordnung isoliert. Ferner folgt die Krümmung des lichtemittierenden Bauelements im Wesentlichen dem gekrümmten Verlauf der Innenfläche des Rohrs. Beispielsweise ist das lichtemittierende Bauelement gebogen ausgeführt und weist in einem Querschnitt senkrecht zur Haupterstreckungsrichtung im Rahmen der Herstellungstoleranz die Form eines Kreisbogens auf. Die von dem Bauelement überdeckten Freibereiche der Innenfläche können dann eine Lichtaustrittsfläche für das von dem lichtemittierenden Bauelement erzeugte Licht bilden.

Gemäß zumindest einer Ausführungsform des Photovoltaikmoduls weist dieses ein mechanisch flexibel ausgebildetes lichtemittierendes Bauelement auf, wobei das lichtemittierende Bauelement die von der Solarzellenanordnung unbedeckten Freibereiche der Innenfläche zumindest stellenweise überdeckt, das lichtemittierende Bauelement elektrisch von der Solarzellenanordnung isoliert ist und die Krümmung des lichtemittierenden Bauelements im Wesentlichen dem gekrümmten Verlauf der Innenfläche folgt.

Gemäß zumindest einer Ausführungsform des Photovoltaikmoduls ist in dem Innenraum an der der Innenfläche abgewandten Bodenfläche des Photovoltaikbauteils ein Akkumulator angeordnet. Beispielsweise wird der Akkumulator vollständig von dem Photovoltaikbauteil und/oder von dem Rohr umschlossen. Der Akkumulator ist hierbei elektrisch leitend mit dem Photovoltaikbauteil verbunden. Bei dem Akkumulator kann es sich beispielsweise um einen Lithium-Ionen-Akkumulator handeln.

Gemäß zumindest einer Ausführungsform des Photovoltaikmoduls ist der Akkumulator dazu eingerichtet, eine durch die Solarzellenanordnung erzeugte elektrische Energie zu speichern. Beispielsweise ist der Akkumulator hierzu elektrisch leitend mit der Solarzellenanordnung verbunden. Ferner ist der Akkumulator dazu eingerichtet, die gespeicherte elektrische Energie zeitverzögert an das lichtemittierende Bauelement abzugeben. Hierzu kann der Akkumulator ebenfalls elektrisch leitend mit dem lichtemittierenden Bauelement verbunden sein. Beispielsweise kann somit bei Sonneneinstrahlung am Tag die durch die Solarzellenanordnung erzeugte elektrische Energie gespeichert werden und anschließend nachts an das lichtemittierende Bauelement zur Lichterzeugung wieder abgegeben werden.

Gemäß zumindest einer Ausführungsform des Photovoltaikmoduls ist in dem Innenraum an der Bodenfläche des Photovoltaikbauteils ein zylinderförmiges Metallrohr angeordnet. Das Metallrohr ist bevorzugt mit einem Metall gebildet oder besteht aus einem Metall. Beispielsweise kann das Metallrohr Kupfer enthalten oder aus Kupfer bestehen. Insbesondere weist das Metallrohr die Form eines Hohlzylinders auf. Das Metallrohr erstreckt sich bevorzugt vollständig entlang der Haupterstreckungsrichtung des Rohrs.

Gemäß zumindest einer Ausführungsform des Photovoltaikmoduls steht das Metallrohr zumindest stellenweise in direktem Kontakt mit dem Photovoltaikbauteil. Insbesondere ist das Metallrohr thermisch leitend mit dem Photovoltaikbauteil verbunden. Das Metallrohr umschließt einen luft- oder wassergefüllten Kühlraum. Bei dem Metallrohr kann es sich somit um ein Kühlrohr handeln, das die von dem Photovoltaikbauteil erzeugte Abwärme an die Umgebung ableitet. Diese Kühlung erfolgt beispielsweise über Luftzirkulation oder Wasserzirkulation innerhalb des Metallrohrs. Hierzu kann natürliche Konvektion ausgenutzt werden und/oder eine Pumpe oder ein Ventilator Verwendung finden.

Es wird ferner ein Photovoltaiksystem angegeben. Das Photovoltaiksystem ist bevorzugt zur Installation im Freien, beispielsweise auf einem Dach eines Hauses oder auf einer landwirtschaftlichen Fläche, vorgesehen. Das Photovoltaiksystem umfasst eine Vielzahl hier beschriebener Photovoltaikmodule. Das heißt, sämtliche für das Photovoltaikmodul offenbarten Merkmale sind auch für das Photovoltaiksystem offenbart und umgekehrt.

Gemäß zumindest einer Ausführungsform des Photovoltaiksystems umfasst dieses eine Vielzahl von Photovoltaikmodulen. Bevorzugt stehen die Photovoltaikmodule nicht in direktem physischen Kontakt zueinander. Mit anderen Worten, zwischen den Photovoltaikmodulen ist jeweils ein durchgängiger Freiraum angeordnet. Die Ausdehnung des Freiraums, das heißt, der Abstand der Photovoltaikmodule, kann hierbei abhängig von dem gewünschten Einsatzgebiet gewählt werden. Die Photovoltaikmodule können elektrisch miteinander verbunden sein. Die Photovoltaikmodule können hierbei seriell und/oder parallel verschaltet sein.

Gemäß zumindest einer Ausführungsform des Photovoltaiksystems umfasst dieses ferner eine Vielzahl von Halterungen und zumindest zwei Befestigungsrohre. Bei den Halterungen kann es sich um mechanische Komponenten handeln, die zur Befestigung der Photovoltaikmodule an den zwei Befestigungsrohren vorgesehen sind. Die Befestigungsrohre können Befestigungselemente aufweisen, die beispielsweise der Befestigung der Halterungen an den Befestigungsrohren dienen.

Gemäß zumindest einer Ausführungsform des Photovoltaiksystems ist jedes Photovoltaikmodul mechanisch mit zumindest einer Halterung verbunden. Beispielsweise erfolgt die mechanische Verbindung mittels einer Steckverbindung, einer Schraubverbindung, einer Klebeverbindung und/oder einer Klemmverbindung.

Gemäß zumindest einer Ausführungsform des Photovoltaiksystems ist jede Halterung an zumindest einem Befestigungsrohr mechanisch bedingt lösbar befestigt. "Mechanisch bedingt lösbar befestigt" bedeutet hierbei und im Folgenden, dass die Befestigung an den Halterungen an dem Befestigungsrohr zerstörungsfrei lösbar ist. Insbesondere wird das Befestigungsrohr bei einer Lösung der Verbindung nicht zerstört. Beispielsweise erfolgt die Befestigung der Halterung an dem Befestigungsrohr unter Verwendung einer Steckverbindung, einer Schraubverbindung und/oder einer Klemmverbindung. Die mechanisch bedingt lösbare Befestigung ermöglicht einen einfachen und kostenreduzierten Austausch einzelner Photovoltaikmodule des Photovoltaiksystems. Hierdurch kann bei einem defekten Photovoltaikmodul der Austausch des gesamten Photovoltaiksystems vermieden werden.

Gemäß zumindest einer Ausführungsform des Photovoltaiksystems umfasst dieses eine Vielzahl von Photovoltaikmodulen, eine Vielzahl von Halterungen und zumindest zwei Befestigungsrohre, wobei jedes Photovoltaikmodul mechanisch mit zumindest einer Halterung verbunden ist und jede Halterung an zumindest einem Befestigungsrohr mechanisch bedingt lösbar befestigt ist.

Bei dem Photovoltaiksystem wird insbesondere die Idee verfolgt, ein wartungsarmes System zur Erzeugung von Strom zur Verfügung zu stellen. Die Verwendung von zylinderförmigen Photovoltaikmodulen mit einer im Vergleich zu flächigen Modulen erhöhten Außenfläche ermöglicht insbesondere eine bessere Ausnutzung der zu belegenden Fläche. Bei einer zu belegenden Fläche kann es sich beispielsweise um eine Dachbeziehungsweise landwirtschaftliche Fläche handeln.

Durch das Vorhandensein von Freiräumen zwischen den Photovoltaikmodulen und der dadurch abschattungsfreien Ausführung ist insbesondere die Verwendung des Photovoltaiksystems in Verbindung mit landwirtschaftlichen Flächen möglich. Hierdurch kann die landwirtschaftliche Fläche unterhalb der Photovoltaiksysteme weiterhin bestellt werden, da insbesondere Regenwasser und/oder Sonnenlicht durch die Freiräume dringen kann. Somit kann beispielsweise Regenwasser weiterhin zur Bewässerung dienen. Die jeweilige räumliche Ausdehnung der Photovoltaikmodule und der Abstand zwischen den Photovoltaikmodulen kann hierbei abhängig vom Anwendungsbereich gewählt werden.

Ferner ist es durch die mechanisch bedingt lösbare Befestigung der Halterung an dem Befestigungsrohr möglich, den Wartungsaufwand des Photovoltaiksystems erheblich zu reduzieren. So können einzelne Photovoltaikmodule ausgetauscht werden, ohne dass das Gesamtsystem verändert werden muss. Der Austausch der einzelnen Photovoltaikmodule in dem Photovoltaiksystem kann somit in "Plug-and-Play"-artiger Weise einfach erfolgen.

Gemäß zumindest einer Ausführungsform des Photovoltaiksystems verlaufen die Haupterstreckungsrichtungen der Vielzahl von Photovoltaikmodulen im Rahmen der Herstellungstoleranzen parallel zueinander. Mit anderen Worten, das Photovoltaiksystem umfasst eine Vielzahl von zylinderförmigen Photovoltaikmodulen, die parallel zueinander angeordnet sind. Zwischen den Photovoltaikmodulen können dann Freiräume angeordnet sein.

Im Folgenden werden das hier beschriebene Photovoltaikmodul und das hier beschriebene Photovoltaiksystem anhand von Ausführungsbeispielen und den dazugehörigen Figuren näher erläutert.
Die Figur 1 zeigt ein Ausführungsbeispiel eines hier beschriebenen Photovoltaikmoduls anhand einer schematischen Schnittdarstellung.
Die Figur 2 zeigt ein Ausführungsbeispiel eines hier beschriebenen Photovoltaikmoduls anhand einer schematischen perspektivischen Ansicht.
Die Figur 3 zeigt ein Ausführungsbeispiel eines hier beschriebenen Photovoltaikmoduls anhand einer schematischen Schnittdarstellung.
Die Figuren 4, 5, 6 und 7 zeigen Ausführungsbeispiele eines hier beschriebenen Photovoltaiksystems anhand schematischer Darstellungen. Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

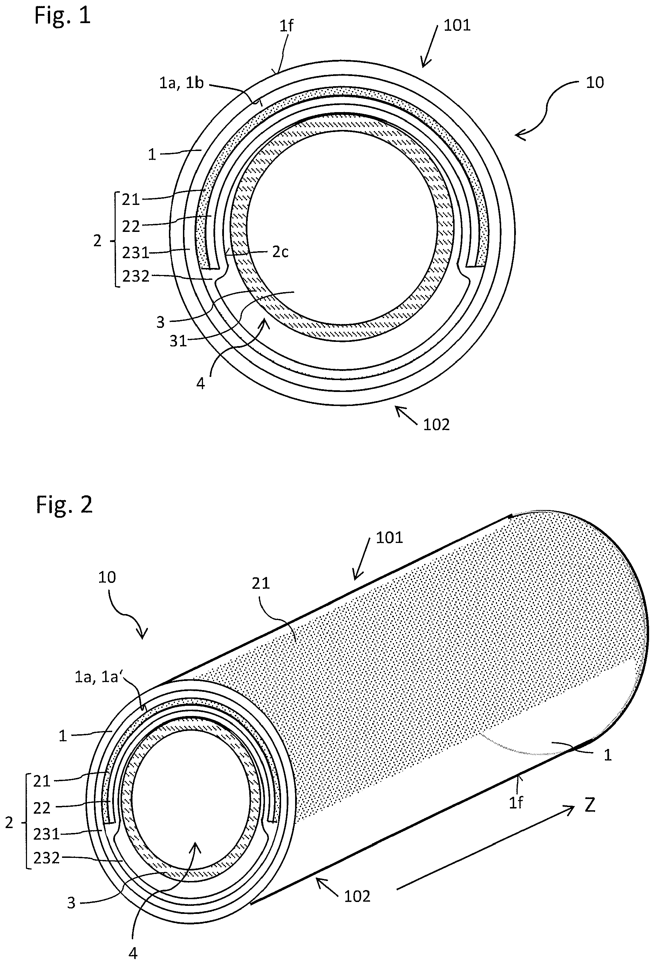

Gemäß der schematischen Schnittdarstellung der Figur 1 ist ein Ausführungsbeispiel eines hier beschriebenen Photovoltaikmoduls 10 näher erläutert. Der dargestellte Querschnitt verläuft hierbei senkrecht zu einer Haupterstreckungsrichtung Z des Photovoltaikmoduls 10. Die Haupterstreckungsrichtung Z verläuft somit in die Zeichenebene hinein.

Das Photovoltaikmodul 10 umfasst ein lichtdurchlässiges Rohr 1, dessen Querschnitt vorliegend die Form eines Kreisrings aufweist. Das Rohr 1 umschließt einen kreisförmigen Innenraum 4 und weist eine dem Innenraum 4 zugewandte Innenfläche 1a und eine der Innenfläche 1a abgewandte Außenfläche 1f auf. Ein Teil der Innenfläche 1a bildet eine Lichtdurchtrittsfläche 1b. Hierbei und im Folgenden sind geometrische eine Bezeichnung wie "kreisförmig" im Rahmen der Herstellungstoleranzen zu verstehen. Beispielsweise kann der Innenraum 4 auch einen ellipsenförmigen Aufbau aufweisen.

Das Photovoltaikmodul 10 weist ferner ein Photovoltaikbauteil 2 auf. Das Photovoltaikbauteil 2 umfasst vorliegend zumindest zwei stoffschlüssig miteinander verbundene Einkapselungsfolien 231, 232. Die Einkapselungsfolien 231, 232 stehen zumindest stellenweise in direktem Kontakt miteinander und sind an diesen Stellen bevorzugt stoffschlüssig miteinander verbunden.

Das Photovoltaikbauteil 2 umfasst ferner eine Solarzellenanordnung 21 und eine Trägerfolie 22, auf welcher die Solarzellenanordnung 21 aufgebracht ist. Bei der Solarzellenanordnung 21 kann es sich beispielsweise um eine CIGS-Solarzellenanordnung oder um eine organische Solarzellenanordnung handeln. Die Trägerfolie 22 kann beispielsweise mit einem Metall oder einem Kunststoff gebildet sein. Die Solarzellenanordnung 21 und die Trägerfolie 22 sind vollständig zwischen den zumindest zwei Einkapselungsfolien 231, 232 angeordnet. In dem Bereich, in dem keine Solarzellenanordnung 21 vorhanden ist, grenzen die beiden Einkapselungsfolien 231, 232 direkt aneinander.

In dem in der Figur 1 dargestellten Ausführungsbeispiel bedecken die beiden Einkapselungsfolien 231, 232 die Innenfläche 1a vollständig. Es ist alternativ möglich - anders als in der Figur 1 gezeigt - dass die Innenfläche 1a stellenweise frei von den Einkapselungsfolien 231, 232 ist. Beispielsweise bedecken die Einkapselungsfolien 231, 232 dann nur die Solarzellenanordnung 21 und Randbereiche um die Solarzellenanordnung 21 herum, die zur stoffschlüssigen Verbindung der Einkapselungsfolien 231, 232 benötigt werden.

Das Photovoltaikbauteil 2 ist in dem Innenraum 4 angeordnet. Die Solarzellenanordnung 21 des Photovoltaikbauteils 2 weist hierbei eine Krümmung auf. Vorliegend weist die Solarzellenanordnung 21 die Form eines Kreisbogens und die Krümmung des zugehörigen Kreises auf. Die Krümmung des Kreisbogens der Solarzellenanordnung 21 folgt hierbei der Krümmung der Innenfläche 1a des Rohrs. Die Trägerfolie 22 und die Einkapselungsfolien 231, 232 weisen ebenfalls eine Krümmung auf, die der Krümmung der Innenfläche 1a zumindest stellenweise folgt.

In dem Bereich, in dem die Solarzellenanordnung 21 die Innenfläche 1a des Rohrs 1 überdeckt, bildet die Innenfläche 1a die Lichtdurchtrittsfläche 1b. Der die Lichtdurchtrittsfläche 1b aufweisende Teil des Photovoltaikmoduls 10 bildet eine Oberseite 101 des Photovoltaikmoduls 10, während der Teil ohne die Lichtdurchtrittsfläche die Unterseite 102 bildet.

In dem Innenraum 4 ist ferner ein Metallrohr 3, das einen Kühlrahmen 31 umschließt, angeordnet. Eine der Innenfläche 1a abgewandte Bodenfläche 2c des Photovoltaikbauteils 2 weist hierbei in Richtung des Metallrohrs 3. Das Metallrohr 3 steht hierbei in direktem Kontakt mit dem Photovoltaikbauteil 2. Hierzu ist das Metallrohr 3 vorliegend exzentrisch angeordnet. Mit anderen Worten, das Metallrohr 3 ist nicht zentriert in Bezug auf das Rohr 1 angeordnet. Das Metallrohr 3 ist vollständig von dem Photovoltaikbauteil 2 und dem Rohr 1 umschlossen. Beispielsweise dient das Metallrohr 3 der Kühlung des Photovoltaikbauteils 2. Hierzu kann der Kühlraum 31 des Metallrohrs 3 mit Wasser und/oder Luft gefüllt sein.

Gemäß der schematischen perspektivischen Ansicht der Figur 2 ist ein weiteres Ausführungsbeispiel eines hier beschriebenen Photovoltaikmoduls 10 näher erläutert. Das dargestellte Photovoltaikmodul 10 entspricht hierbei dem Photovoltaikmodul 10 der Figur 1.

Das Rohr 1 ist länglich ausgebildet und erstreckt sich entlang der Haupterstreckungsrichtung Z. Senkrecht zur Haupterstreckungsrichtung Z weist das Rohr 1 den in der Figur 1 gezeigten Querschnitt auf. Die Solarzellenanordnung 21 des Photovoltaikbauteils 2 erstreckt sich ebenfalls entlang der Haupterstreckungsrichtung Z. In einer Aufsicht auf die Oberseite 101 bildet die Solarzellenanordnung 21 hierbei eine durchgängige Fläche. Die Lichtdurchtrittsfläche 1b ist dann einfach zusammenhängend ausgebildet. Beispielsweise weist die Solarzellenanordnung 21 in einer Aufsicht auf die Oberseite 101 die Form eines abgerundeten Rechtecks auf.

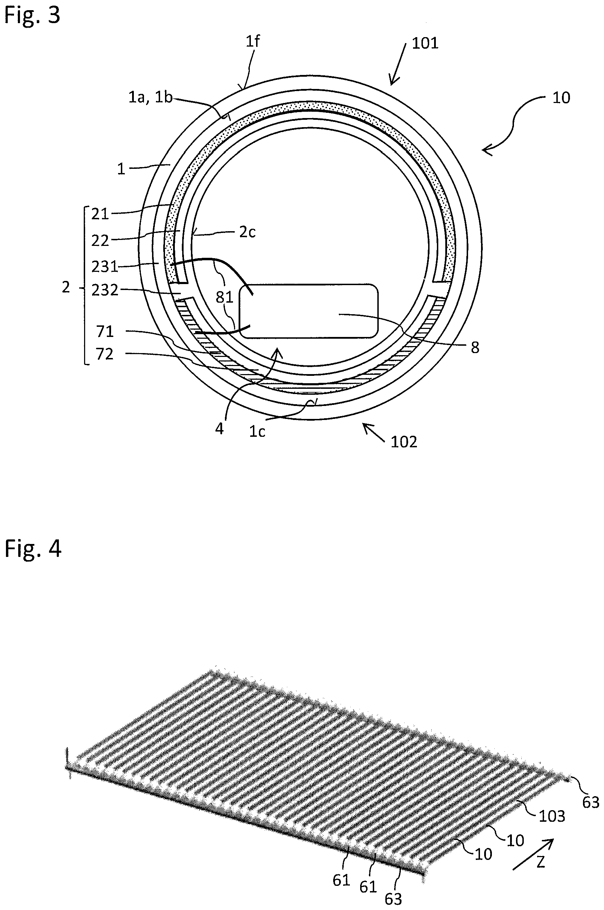

Gemäß der schematischen Schnittdarstellung der Figur 3 ist ein weiteres Ausführungsbeispiel eines hier beschriebenen Photovoltaikmoduls 10 näher erläutert. Das hier dargestellte Photovoltaikmodul 10 unterscheidet sich von dem der Figur 1 durch das Vorhandensein eines lichtemittierenden Bauelements 71, 72 und eines Akkumulators 8.

Das lichtemittierende Bauelement 71, 72 überdeckt von der Solarzellenanordnung 21 unbedeckte Freibereiche 1c der Innenfläche 1a zumindest stellenweise. Beispielsweise ist die Solarzellenanordnung 21 - wie hier dargestellt - an der Oberseite 101 des Photovoltaikmoduls 10 angeordnet, während das lichtemittierende Bauelement 71, 72 an der Unterseite 102 angeordnet ist. Das lichtemittierende Bauelement 71, 72 umfasst hierbei lichtemittierende Schichten 71 und eine Trägerschicht 72. Beispielsweise sind die lichtemittierenden Schichten 71 mit organischen Schichten gebildet. Es ist ferner möglich, dass die lichtemittierenden Schichten 71 anorganische Schichten enthalten. Hierbei ist es möglich, dass die lichtemittierende Schicht 71 nicht durchgängig ausgebildet ist, sondern vielmehr in einzelne Segmente unterteilt ist, um eine Flexibilität des lichtemittierenden Bauelements 71, 72 zu gewährleisten.

Im Innenraum 4 des Rohrs 1 ist ferner der Akkumulator 8 angeordnet. Der Akkumulator 8 ist elektrisch leitend mit dem Photovoltaikbauteil 2 verbunden. Beispielsweise sind elektrische Verbindungen 81 zu der Solarzellenanordnung 21 und zu dem lichtemittierenden Bauelement 71, 72 vorgesehen.

Gemäß der schematischen Darstellung der Figur 4 ist ein Ausführungsbeispiel eines hier beschriebenen Photovoltaiksystems näher erläutert. Das Photovoltaiksystem weist eine Vielzahl von Photovoltaikmodulen 10 auf. Die Haupterstreckungsrichtungen Z der Photovoltaikmodule 10 verlaufen im Rahmen der Herstellungstoleranzen parallel zueinander. Zwischen den Photovoltaikmodulen 10 ist jeweils ein Freiraum 101 angeordnet. Durch diesen Freiraum 101 kann bei einem Betrieb im Freien beispielsweise Regenwasser hindurchtreten. Die Photovoltaikmodule 10 sind mittels Halterungen 61 an zwei Befestigungsrohren 63 angebracht. Die Befestigungsrohre 63 verlaufen vorliegend vertikal zu den Haupterstreckungsrichtungen Z der Photovoltaikmodule 10.

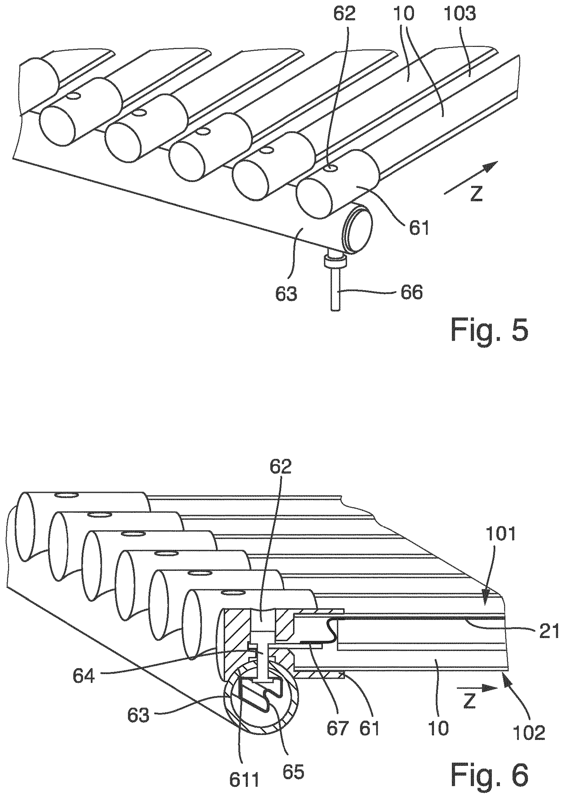

Gemäß der schematischen Darstellung der Figur 5 ist ein weiteres Ausführungsbeispiel eines hier beschriebenen Photovoltaiksystems näher erläutert. Hierbei ist eine Vergrößerung eines Ausschnitts des in der Figur 4 dargestellten Photovoltaiksystems gezeigt.

Die Halterungen 63 weisen jeweils ein Schraubenloch 62 auf, durch das eine Schraube 64 (hier nicht gezeigt) geführt werden kann. Mittels einer Schraube 64 kann die Halterung 62 mechanisch bedingt lösbar mit dem Befestigungsrohr 63 verbunden werden. Ferner weist das Photovoltaiksystem eine von außen frei zugängliche Kontaktierung 66 auf, die der elektrischen Kontaktierung der Photovoltaikmodulen 10 dient.

Die Halterungen 61 sind mechanisch mit den Photovoltaikmodulen 10 verbunden. Vorliegend sind jeweils zwei Halterungen 61 einem Photovoltaikmodul 10 zugeordnet. Es ist ferner möglich - anders als in den Figuren gezeigt - dass jedem Photovoltaikmodul 10 lediglich eine oder mehr als zwei Halterungen 61 zugeordnet sind. Beispielsweise sind die Halterungen 61 über eine Steckverbindung, eine Schraubverbindung und/oder eine Klemmverbindung mit dem zugehörigen Photovoltaikmodul 10 verbunden. Die Verbindung und das Haltern kann beispielsweise ähnlich wie bei einer Leuchtstoffröhre erfolgen.

Gemäß der schematischen Darstellung der Figur 6 ist ein Ausführungsbeispiel eines hier beschriebenen Photovoltaiksystems näher erläutert. Das dargestellte Photovoltaiksystem entspricht dem der Figuren 4 und 5, wobei ein Querschnitt durch ein Photovoltaikmodul 10 und ein Befestigungsrohr 63 entlang der Haupterstreckungsrichtung 10 dargestellt ist. Die Halterung 61 weist im Bereich des Befestigungsrohrs 63 Ausnehmungen 611 auf, um einen bündigen Abschluss der Halterung 61 mit dem Befestigungsrohr 63 zu ermöglichen.

Das Photovoltaikmodul 10 ist über eine Schraube 64, die durch das Schraubenloch 62 geführt ist, mechanisch bedingt lösbar mit dem Befestigungsrohr 63 verbunden. Für die mechanisch bedingt lösbare Verbindung weist das Befestigungsrohr 63 in seinem Inneren ein Befestigungselement 65 auf, in das die Schraube 64 eingreift. Die Schraube 64 ist ferner elektrisch leitend mit einem Kontaktelement 67 verbunden, das wiederum elektrisch leitend mit der Solarzellenanordnung 21, die an der dem Befestigungsrohr 63 abgewandten Oberseite 101 des Photovoltaikmoduls 10 angeordnet ist, verbunden ist. Das Befestigungselement 65 dient somit sowohl der mechanischen Verbindung der Halterung 62 mit dem Befestigungsrohr 63 als auch der elektrischen Kontaktierung der Solarzellenanordnung 21 des Photovoltaikmoduls 10.

Durch die mechanisch bedingt lösbare Verbindung der Halterung 61 mit dem Befestigungsrohr 63 ist es insbesondere möglich, einzelne Photovoltaikmodule 10 mit wenig Aufwand auszutauschen. Hierdurch kann ein wartungsarmes Photovoltaiksystem bereitgestellt werden.

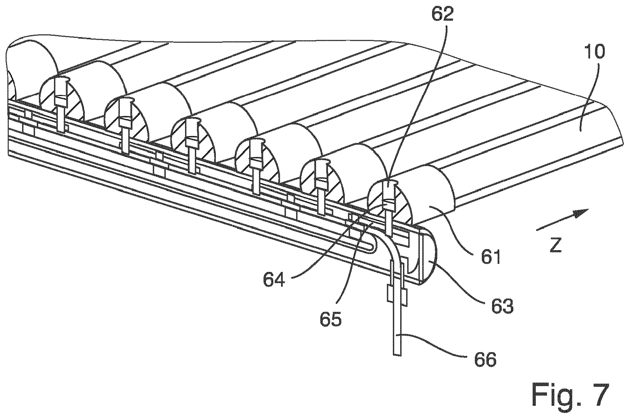

Gemäß der schematischen Darstellung der Figur 7 ist ein weiteres Ausführungsbeispiel eines hier beschriebenen Photovoltaiksystems näher erläutert. Das dargestellte Photovoltaiksystem entspricht dem der Figuren 4 bis 6, wobei ein Querschnitt durch ein Befestigungsrohr 63 und die Halterungen 61 senkrecht zur Haupterstreckungsrichtung Z dargestellt ist. Die Schrauben 64 greifen in die Befestigungselemente 65 ein. Diese sind wiederum elektrisch leitend mit der Kontaktierung 66 verbunden. Die Befestigungselemente 65 erstrecken sich zumindest teilweise entlang des Befestigungsrohrs 63. Vorliegend sind jeweils zwei Schrauben 64 mit einem Befestigungselement 65 verbunden.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Anmeldung beansprucht die Priorität der deutschen Anmeldung DE 10 2014 225 631.3, deren Offenbarungsgehalt hiermit durch Rückbezug aufgenommen wird.

### Bezugszeichenliste:

- Z: Haupterstreckungsrichtung
- 10: Photovoltaikmodul
- 101: Oberseite
- 102: Unterseite
- 103: Freiraum
- 1: Rohr
- 1a: Innenfläche
- 1b: Lichtdurchtrittsfläche
- 1c: Lichtaustrittsfläche
- 1f: Außenfläche
- 2: Photovoltaikbauteil
- 21: Solarzellenanordnung
- 22: Trägerfolie
- 231, 232: Einkapselungsfolien
- 2c: Bodenfläche
- 3: Metallrohr
- 31: Kühlraum
- 4: Innenraum
- 61: Halterung
- 611: Ausnehmung
- 62: Schraubenloch
- 63: Befestigungsrohr
- 64: Schraube
- 65: Befestigungselement
- 66: Kontaktierung
- 67: Kontaktelement
- 71: lichtemittierende Schichten
- 72: Trägerschicht
- 8: Akkumulator
- 81: elektrische Verbindungen

## Patentansprüche

1. Photovoltaikmodul (10) umfassend
- ein einen Innenraum (4) umschließendes lichtdurchlässiges Rohr (1) mit einer Haupterstreckungsrichtung (Z), und einer dem Innenraum zugewandten gekrümmten Innenfläche (1a) und
- ein mechanisch flexibles Photovoltaikbauteil (2) mit einer auf einer Trägerfolie (22) aufgebrachten Solarzellenanordnung (21) wobei
- das Photovoltaikbauteil (2) in dem Innenraum (4) angeordnet ist,
- die Solarzellenanordnung (21) eine Krümmung aufweist, wobei die Krümmung zumindest stellenweise dem gekrümmten Verlauf der Innenfläche (1a) des Rohrs (1) folgt und
- die Solarzellenanordnung (21) die Innenfläche (1a) zumindest teilweise überdeckt, wobei die überdeckte
Innenfläche (1a) eine Lichtdurchtrittsfläche (1b) des Photovoltaikmoduls (10) bildet,
**dadurch gekennzeichnet, dass**
das Photovoltaikbauteil (2) zumindest zwei stoffschlüssig miteinander verbundene Einkapselungsfolien (231, 232) aufweist,
wobei
- die Solarzellenanordnung (21) vollständig zwischen den Einkapselungsfolien (231, 232) angeordnet ist,
- die Einkapselungsfolien (231, 232) thermoplastische Folien sind, und
- die Einkapselungsfolien (231, 232) zumindest stellenweise in direktem Kontakt miteinander stehen.

2. Photovoltaikmodul (10) nach einem der vorherigen Ansprüche, wobei zumindest eine Einkapselungsfolie (231, 232) die Solarzellenanordnung (21) an einer Außenfläche bedeckt.

3. Photovoltaikmodul (10) nach einem der vorherigen Ansprüche, bei dem die Solarzellenanordnung (21) in einem Querschnitt senkrecht zur Haupterstreckungsrichtung (Z) im Rahmen der Herstellungstoleranzen zumindest stellenweise die Form eines Kreisbogens aufweist.

4. Photovoltaikmodul (10) nach einem der vorherigen Ansprüche, bei dem wenigstens 30 % und bis zu 100 % der Innenfläche (1a) des Rohrs (1) von der Solarzellenanordnung (21) überdeckt sind.

5. Photovoltaikmodul (10) nach einem der vorherigen Ansprüche, bei dem die Lichtdurchtrittsfläche (1b) eine einfach zusammenhängende Fläche ist.

6. Photovoltaikmodul (10) nach einem der vorherigen Ansprüche, bei dem das Photovoltaikbauteil (2) senkrecht zur Haupterstreckungsrichtung (Z) vollständig von dem Rohr (1) umschlossen ist.

7. Photovoltaikmodul (10) nach einem der vorherigen Ansprüche, bei dem die Solarzellenanordnung (21) unter Verwendung eines Druckprozesses auf die Trägerfolie (22) aufgebracht ist.

8. Photovoltaikmodul (10) nach einem der vorherigen Ansprüche, bei dem die Solarzellenanordnung (21) eine CIGS-Solarzellenanordnung oder eine organische Solarzellenanordnung ist.

9. Photovoltaikmodul (10) nach einem der vorherigen Ansprüche, bei dem die Solarzellenanordnung (21) eine Dicke von höchstens 5 um, bevorzugt höchstens 2,5 um, aufweist.

10. Photovoltaikmodul (10) nach einem der vorherigen Ansprüche, bei dem das Photovoltaikbauteil ein mechanisch flexibel ausgebildetes lichtemittierendes Bauelement (71, 72) aufweist, wobei
- das lichtemittierende Bauelement (71, 72) von der Solarzellenanordnung (21) unbedeckte Freibereiche (1c) der Innenfläche (1a) zumindest stellenweise überdeckt,
- das lichtemittierende Bauelement (71, 72) elektrisch von der Solarzellenanordnung (21) isoliert ist und
- die Krümmung des lichtemittierenden Bauelements (71, 72) im Wesentlichen dem gekrümmten Verlauf der Innenfläche (1a) folgt.

11. Photovoltaikmodul (10) nach einem der vorherigen Ansprüche, bei dem in dem Innenraum (4) an einer der Innenfläche (1a) abgewandten Bodenfläche (2c) des Photovoltaikbauteils (2) ein Akkumulator (8) angeordnet ist, wobei der Akkumulator (8) elektrisch leitend mit dem Photovoltaikbauteil (2) verbunden ist.

12. Photovoltaikmodul (10) nach dem der vorherigen Anspruch, bei dem der Akkumulator (8) dazu eingerichtet ist, eine durch die Solarzellenanordnung (21) erzeugte elektrische Energie zu speichern und zeitverzögert an das lichtemittierende Bauelement (71, 72) abzugeben.

13. Photovoltaikmodul (10) nach einem der vorherigen Ansprüche, bei dem in dem Innenraum (4) an der Bodenfläche (2c) ein zylinderförmiges Metallrohr (3) angeordnet ist, wobei bevorzugt das Metallrohr (3)
- zumindest stellenweise in direktem Kontakt mit dem Photovoltaikbauteil (2) steht und
- einen luft- oder wassergefüllten Kühlraum (31) umschließt.

14. Photovoltaiksystem umfassend
- eine Vielzahl von Photovoltaikmodulen (10) nach einem der vorherigen Ansprüche,
- eine Vielzahl von Halterungen (61) und
- zumindest zwei Befestigungsrohre (63), wobei
- jedes Photovoltaikmodul (10) mechanisch mit zumindest einer Halterung (61) verbunden ist und
- jede Halterung (61) an zumindest einem Befestigungsrohr (63) mechanisch bedingt lösbar befestigt ist.

15. Photovoltaiksystem nach dem vorherigen Anspruch bei dem die Haupterstreckungsrichtungen (Z) der Vielzahl von Photovoltaikmodulen (10) im Rahmen der Herstellungstoleranzen parallel zueinander verlaufen.

## Claims

1. Photovoltaic module (10), comprising
- a translucent tube (1) encompassing an inner space (4), with a main direction of extent (Z), and a curved inner face (1a) facing the inner space, and
- a mechanically flexible photovoltaic component (2) with a solar cell arrangement (21) applied to a carrier film (22), wherein
- the photovoltaic component (2) is arranged in the inner space (4),
- the solar cell arrangement (21) has a curvature, wherein the curvature at least in places follows the curved course of the inner face (1a) of the tube (1), and
- the solar cell arrangement (21) at least partially covers the inner face (1a), wherein the covered inner face (1a) forms a light passage surface (1b) of the photovoltaic module (10),
**characterised in that**
the photovoltaic component (2) has at least two encapsulation films (231, 232) connected together by a material-formed bond, wherein
- the solar cell arrangement (21) is arranged completely between the encapsulation films (231, 232),
- the encapsulation films (231, 232) are thermoplastic films, and
- the encapsulation films (231, 232) at least in places are in direct contact with each other.

2. Photovoltaic module (10) according to one of the preceding claims, wherein at least one encapsulation film (231, 232) covers the solar cell arrangement (21) on an outer face.

3. Photovoltaic module (10) according to one of the preceding claims, in which the solar cell arrangement (21) in a cross-section perpendicularly to the main direction of extent (Z) within the limits of the manufacturing tolerances at least in places is in the form of an arc of a circle.

4. Photovoltaic module (10) according to one of the preceding claims, in which at least 30% and up to 100% of the inner face (1a) of the tube (1) is covered by the solar cell arrangement (21).

5. Photovoltaic module (10) according to one of the preceding claims, in which the light passage surface (1b) is a singly coherent surface.

6. Photovoltaic module (10) according to one of the preceding claims, in which the photovoltaic component (2) perpendicularly to the main direction of extent (Z) is completely encompassed by the tube (1).

7. Photovoltaic module (10) according to one of the preceding claims, in which the solar cell arrangement (21) is applied to the carrier film (22) using a printing process.

8. Photovoltaic module (10) according to one of the preceding claims, in which the solar cell arrangement (21) is a CIGS solar cell arrangement or an organic solar cell arrangement.

9. Photovoltaic module (10) according to one of the preceding claims, in which the solar cell arrangement (21) has a thickness of at most 5 µm, preferably at most 2.5 µm.

10. Photovoltaic module (10) according to one of the preceding claims, in which the photovoltaic component has a mechanically flexibly formed light-emitting component (71, 72), wherein
- the light-emitting component (71, 72), at least in places, covers free regions (1c) of the inner face (1a) which are not covered by the solar cell arrangement (21),
- the light-emitting component (71, 72) is electrically isolated from the solar cell arrangement (21), and
- the curvature of the light-emitting component (71, 72) substantially follows the curved course of the inner face (1a).

11. Photovoltaic module (10) according to one of the preceding claims, in which a storage battery (8) is arranged in the inner space (4) on a base surface (2c) of the photovoltaic component (2) remote from the inner face (1a), wherein the storage battery (8) is connected in an electrically conductive manner to the photovoltaic component (2) .

12. Photovoltaic module (10) according to the preceding claim, in which the storage battery (8) is set up to store electrical energy generated by the solar cell arrangement (21) and to emit it to the light-emitting component (71, 72) after a time delay.

13. Photovoltaic module (10) according to one of the preceding claims, in which a cylindrical metal tube (3) is arranged in the inner space (4) on the base surface (2c), wherein preferably the metal tube (3)
- at least in places is in direct contact with the photovoltaic component (2), and
- encompasses an air-filled or water-filled cooling space (31) .

14. Photovoltaic system, comprising
- a multiplicity of photovoltaic modules (10) according to one of the preceding claims,
- a multiplicity of holders (61), and
- at least two fastening tubes (63), wherein
- each photovoltaic module (10) is connected mechanically to at least one holder (61) and
- each holder (61) is mechanically limitedly detachably fastened to at least one fastening tube (63).

15. Photovoltaic system according to the preceding claim, in which the main directions of extent (Z) of the multiplicity of photovoltaic modules (10) within the limits of the manufacturing tolerances run parallel to each other.

## Revendications

1. Module photovoltaïque (10) comprenant
- un tuyau (1) laissant passer la lumière entourant un espace intérieur (4), avec une direction d'extension principale (Z) et une surface intérieure (1a) incurvée tournée vers l'espace intérieur, et
- un composant photovoltaïque (2) flexible mécaniquement avec un ensemble de cellules solaires (21) installé sur un film de support (22),
dans lequel
- le composant photovoltaïque (2) est disposé dans l'espace intérieur (4),
- l'ensemble de cellules solaires (21) présente une incurvation, dans lequel l'incurvation suit au moins par emplacements le profil incurvé de la surface intérieure (1a) du tuyau (1), et
- l'ensemble de cellules solaires (21) recouvre au moins en partie la surface intérieure (la), dans lequel la surface intérieure (1a) recouverte forme une surface de passage de la lumière (1b) du module photovoltaïque (10),
**caractérisé en ce que**
le composant photovoltaïque (2) présente au moins deux films d'encapsulage (231, 232) reliés l'un à l'autre par liaison de matière,
dans lequel
- l'ensemble de cellules solaires (21) est disposé totalement entre les films d'encapsulage (231, 232),
- les films d'encapsulage (231, 232) sont des films thermoplastiques, et
- les films d'encapsulage (231, 232) sont en contact direct entre eux au moins par emplacements.

2. Module photovoltaïque (10) selon l'une quelconque des revendications précédentes, dans lequel au moins un film d'encapsulage (231, 232) couvre sur une surface extérieure l'ensemble de cellules solaires (21).

3. Module photovoltaïque (10) selon l'une quelconque des revendications précédentes, où l'ensemble de cellules solaires (21) présente dans une section transversale de manière perpendiculaire par rapport à la direction d'extension principale (Z), dans le cadre des tolérances de fabrication, au moins par emplacements la forme d'un arc de cercle.

4. Module photovoltaïque (10) selon l'une quelconque des revendications précédentes, où au moins 30 % et jusqu'à 100 % de la surface intérieure (1a) du tuyau (1) sont recouverts par l'ensemble de cellules solaires (21).

5. Module photovoltaïque (10) selon l'une quelconque des revendications précédentes, où la surface de passage de la lumière (1b) est une surface simplement contiguë.

6. Module photovoltaïque (10) selon l'une quelconque des revendications précédentes, où le composant photovoltaïque (2) est entouré en totalité par le tuyau (1) de manière perpendiculaire par rapport à la direction d'extension principale (Z).

7. Module photovoltaïque (10) selon l'une quelconque des revendications précédentes, où l'ensemble de cellules solaires (21) est installé sur le film de support (22) en utilisant un processus d'impression.

8. Module photovoltaïque (10) selon l'une quelconque des revendications précédentes, où l'ensemble de cellules solaires (21) est un ensemble de cellules solaires à base de CIGS [Copper Indium Gallium Selenide - séléniure de cuivre, d'indium et de gallium] ou un ensemble de cellules solaires organique.

9. Module photovoltaïque (10) selon l'une quelconque des revendications précédentes, où l'ensemble de cellules solaires (21) présente une épaisseur de 5 µm au maximum, de manière préférée de 2,5 µm au maximum.

10. Module photovoltaïque (10) selon l'une quelconque des revendications précédentes, où le composant photovoltaïque présente un élément structurel (71, 72) d'émission de lumière réalisé de manière flexible mécaniquement,
dans lequel
- l'élément structurel (71, 72) d'émission de lumière recouvre au moins par emplacements des zones libres (1c), non recouvertes par l'ensemble de cellules solaires (21), de la surface intérieure (la), - l'élément structurel (71, 72) d'émission de lumière est isolé électriquement de l'ensemble de cellules solaires (21),
et
- l'incurvation de l'élément structurel (71, 72) d'émission de lumière suit sensiblement le profil incurvé de la surface intérieure (1a).

11. Module photovoltaïque (10) selon l'une quelconque des revendications précédentes, où un accumulateur (8) est disposé dans l'espace intérieur (4) sur une surface de fond (2c), opposée à la surface intérieure (1c), du composant photovoltaïque (2), dans lequel l'accumulateur (8) est relié de manière électriquement conductrice au composant photovoltaïque (2).

12. Module photovoltaïque (10) selon la revendication précédente, où l'accumulateur (8) est mis au point pour stocker une énergie électrique produite par l'ensemble de cellules solaires (21) et pour l'envoyer de manière différée à l'élément structurel (71, 72) d'émission de lumière.

13. Module photovoltaïque (10) selon l'une quelconque des revendications précédentes, où un tuyau métallique (3) cylindrique est disposé dans l'espace intérieur (4) sur la surface de fond (2c), dans lequel de manière préférée le tuyau métallique (3)
- est en contact direct au moins par emplacements avec le composant photovoltaïque (2), et
- renferme un espace de refroidissement (31) rempli d'air ou d'eau.

14. Système photovoltaïque comprenant
- une pluralité de modules photovoltaïques (10) selon l'une quelconque des revendications précédentes,
- une pluralité de supports (61), et
- au moins deux tuyaux de fixation (63), dans lequel
- chaque module photovoltaïque (10) est relié mécaniquement à au moins un support (61), et
- chaque support (61) est fixé de manière amovible selon le cas mécaniquement sur au moins un tuyau de fixation (63).

15. Système photovoltaïque selon la revendication précédente, où les directions d'extension principales (A) de la pluralité de modules photovoltaïques (10) s'étendent de manière parallèle les unes par rapport aux autres dans le cadre des tolérances de fabrication.
